# DEMANDE DE BREVET EUROPEEN

(11) **EP 1 258 984 A1**
(43) Date de publication de la demande: **20.11.2002**
(21) Numéro de dépôt: 02368049.9
(22) Date de dépôt: 13.05.2002
(51) Int. Cl.: H03F 3/30, H03F 3/45, H03F 1/08

(54) **Amplificateur différentiel comportant un dispositif de déverrouillage**

(30) Priorité: 14.05.2001 FR 0106302
(71) Demandeur: STMicroelectronics S.A., 92120 Montrouge (FR)
(72) Inventeur: Renous, Claude, 38100 Grenoble (FR)
(74) Mandataire: Schuffenecker, Thierry

(57) **Abrégé**

Amplificateur différentiel comportant un premier étage composé d'un premier et second transistor (10, 20) de même polarité et montés en amplificateur différentiel et alimentés par une première et une seconde source de courant miroir (11, 21). Les sources de courant miroir sont commandées par un circuit de contrôle du mode commun (2, 3, 4, 5) ayant deux entrées recevant respectivement un potentiel de consigne Vcm et le potentiel de mode commun. L'amplificateur comporte un second étage de Miller pour fixer le produit gain-bande et un circuit de déverrouillage inséré entre le potentiel de mode commun et les entrées de l'étage de Miller de manière à provoquer la conduction forcée de cet étage au démarrage du circuit.

## Description

### Domaine technique de l'invention

La présente invention concerne les circuits amplificateurs à semi-conducteurs et notamment un circuit amplificateur différentiel doté d'un dispositif de déverrouillage.

### Etat de la technique

Les amplificateurs différentiels connaissent une large application dans le domaine des télécommunications. Ils permettent en effet le traitement des faibles signaux véhiculant la voix et, plus généralement les données. La structure différentielle est particulièrement privilégiée dans les réseaux de transports de données des réseaux filiaires (*Wide Area Network)* tels qu'on les rencontre pour les réseaux de type *Asynchronous Transfer Mode* (A.T.M.) ou encore *Asynchronous Digital Subscriber Line* (A.D.S.L.) et leurs principaux dérivés H.D.S.L (que l'on désigne communément sous le vocable générique de X.D.S.L.).

D'une manière générale la structure différentielle présente l'avantage décisif d'éliminer les harmoniques et non linéarités d'ordre 2 dans le bruit de distorsion. Elle assure en outre une plus grande immunité par rapport aux perturbations en mode commun, telles que celles affectant les circuits d'alimentation des circuits électroniques.

Les circuits amplificateurs différentiels, notamment ceux utilisant des transistors de type *Métal Oxyde Silicium* (MOS) de type complémentaires que l'on rencontre dans la technologie *bi-CMOS,* ont fréquemment recours à des sources de courant. Il n'est pas rare que de telles sources de courant connaissent des transitoires de démarrage difficiles et des phénomènes de blocage entraînant ainsi pour l'amplificateur une impossibilité de fonctionnement.

On connaît déjà des circuits permettant de pallier ce problème et d'éviter le blocage des sources de courant existant dans un circuit semi-conducteur. La demande de brevet français n° 2767976 intitulée « Dispositif d'aide au démarrage pour une pluralité de sources de courant » décrit ainsi un tel dispositif d'aide au démarrage qui, s'il n'est pas spécifiquement adapté à la structure des amplificateurs, présente une utilité certaine pour les dispositifs d'alimentation de microprocesseurs et d'équipements électroniques. Ce dispositif comporte un circuit d'aide au démarrage qui fournit un courant de démarrage aux sources de courant pendant une période transitoire, le temps nécessaire à l'établissement d'un régime permanent. Un dispositif complémentaire d'inhibition est ensuite requis pour le fonctionnement en régime permanent.

Les amplificateurs différentiels étant particulièrement importants dans les circuits intégrés utilisés dans les télécommunications, il reste souhaitable de concevoir des dispositifs d'aide au démarrage particulièrement adaptés à leur structure et permettant, sans ajout de nombreux circuits supplémentaires, une mise en oeuvre simple et peu onéreuse sur le plan industriel. On ne dispose pas encore d'une structure d'amplificateur différentielle qui intégre directement et simplement un circuit de déverrouillage parfaitement adapté.

### Exposé de l'invention

La présente invention a pour but de proposer une structure d'amplificateur différentielle qui est dotée d'un dispositif de déverrouillage simple, parfaitement efficace et ne nécessitant qu'un nombre très réduit de composants supplémentaires.

Un autre but de la présente invention consiste à proposer un dispositif de déverrouillage parfaitement adapté à l'architecture d'un amplificateur différentiel qui est destiné à être intégré dans un circuit intégré, et utilisant notamment des composants de type CMOS de la technologie bi-CMOS.

C'est un autre but de la présente invention que de fournir une structure d'amplificateur différentielle parfaitement adaptée aux exigences des réseaux de télécommunications, et notamment les liaisons de type A.S.D. L. ou H.S.D.L.

L'invention réalise ces buts au moyen d'une structure d'amplificateur différentiel comportant un premier étage composé d'un premier et second transistor de même polarité - par exemple de type NMOS - et qui sont montés en amplificateur différentiel. Les premier et second transistors sont respectivement alimentés par une première et une seconde source de courant miroir commandées par un circuit de contrôle gérant le mode commun. Le circuit de contrôle du mode commun dispose de deux entrées recevant respectivement un potentiel de consigne V_{cm} et un potentiel représentatif du potentiel de mode commun de l'amplificateur. Un second étage de Miller comportant un troisième et quatrième transistor de type inverse des précédents - par exemple PMOS - et dont les entrées reçoivent les signaux de sortie du premier étage est utilisé pour accroître le gain en boucle ouverte du circuit amplificateur et fixer le produit gain-bande de l'amplificateur. Un circuit supplémentaire de déverrouillage est inséré entre le potentiel de mode commun et les entrées de l'étage de Miller de manière à provoquer la conduction forcée des troisièmes et quatrièmes transistors de type PMOS tant que le potentiel de mode commun n'a pas atteint une valeur significativement proche de la valeur de consigne.

Ainsi se trouve assurée la mise en conduction de l'étage de Miller et, par effet de ricochet, la mise en conduction desdites première et seconde sources de courant et assure ainsi le fonctionnement de l'amplificateur. Dès que le potentiel de mode commun remonte à une valeur de fonctionnement normale, le circuit de déverrouillage se trouve bloqué et rétablit l'impédance entre la sortie de l'étage de Miller et le potentiel de mode commun, permettant ainsi le fonctionnement de l'amplificateur dans un mode linéaire.

Préférentiellement, le circuit de déverrouillage est réalisé au moyen de deux transistors de type MOS assurant la mise en court-circuit entre le potentiel de mode commun et les entrées de l'étage de Miller. Le drain de chacun des transistors NMOS (lesquels peuvent être également des transistors NPN) ou de déverrouillage est connecté à la grille correspondante de l'un des troisième et quatrième transistors. En outre, les deux transistors de déverrouillage présentent une source connectée à l'électrode représentative du potentiel de mode commun et leur grille est connectée à l'électrode de consigne V_{cm} de manière à provoquer la mise en conduction des transistors des étages de Miller dès lors que la valeur réelle du potentiel de mode commun est inférieure d'une manière significative à ladite valeur de consigne V_{cm}.

Dans un mode réalisation particulier, l'amplificateur peut être doté d'un étage cascode ou suiveur comportant, par exemple, des transistors bipolaire.

Plus particulièrement, l'amplificateur différentiel comporte
- un premier étage comportant un premier et second transistors de type NMOS (qui peuvent être également des transistors de type NPN) montés en paire différentielle dont les grilles reçoivent les signaux d'entrées (E1, E2) via des résistances de contre-réaction, dont la source commune est connectés à une troisième source de courant ;
- un second étage de gain de Miller comportant un troisième et quatrième transistor, par exemple de type PMOS, montés en source commune, associés chacun à une source de courant et à un condensateur, la sortie du second étage de gain de Miller étant connectées aux électrodes de sorties (01, 02) et présentant une entrée ;
- un cinquième et sixième transistor, par exemple de type PMOS, destinés à réaliser ladite première et seconde source de courant alimentant respectivement les premiers et second transistors de type NMOS formant la paire différentielle, lesdits cinquième et sixième transistor étant montés en source commune et présentant un drain qui est connecté au drain correspondant desdits premier et second transistor de la paire différentielle, ainsi qu'une grille qui est commandée par ledit circuit de gestion du mode commun.
- un circuit de déverrouillage comportant un septième et huitième transistors, par exemple de type NMOS, présentant une grille recevant la valeur de consigne Vcm et servant à court-circuiter ledit potentiel de mode commun et la grille desdits troisième et quatrième transistors formant l'étage de Miller dès lors que la tension de mode commun descend en deçà de la valeur de consigne V_{cm}.

L'invention est particulièrement adaptée à la conception d'amplificateur large bande utilisée en télécommunication filiaires, et notamment, suivant les vocables anglo-saxons, de type Asynchronous Digital Line Subscriber (A.D.S.L), et leurs dérivés.

### Description des dessins

La figure 1 illustre un exemple de circuit d'amplificateur différentiel, comportant un étage de gain de Miller, qui peut avantageusement être doté d'un circuit de déverrouillage.

La figure 2 illustre la structure d'amplificateur différentiel disposant d'un tel circuit de déverrouillage.

La figure 3 illustre une seconde réalisation comportant un circuit cascode supplémentaire.

### Description d'un mode de réalisation préféré

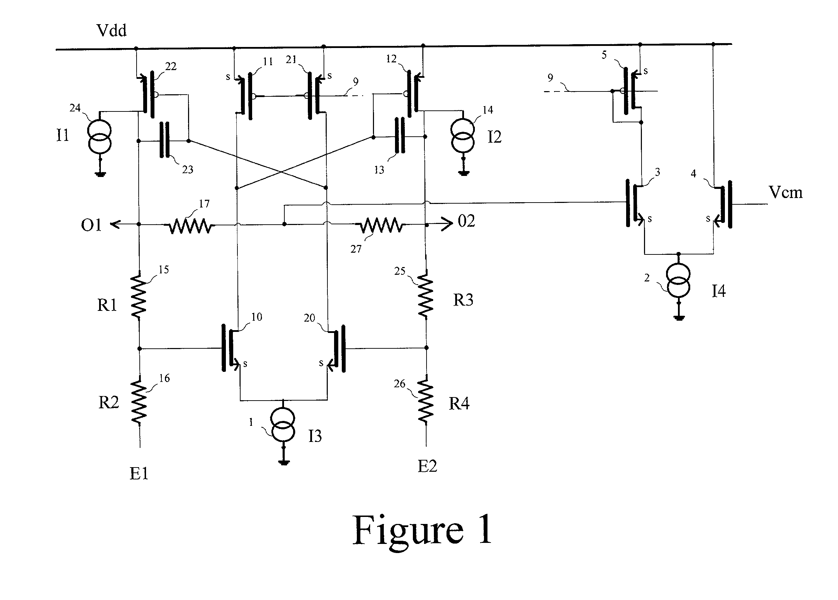

La figure 1 illustre un exemple d'amplificateur différentiel, comportant un étage de gain de Miller, et qui peut avantageusement être doté du circuit de déverrouillage que l'on décrira plus loin. L'amplificateur différentiel comporte une paire de transistors 10 et 20 de type NMOS. Bien que le mode de réalisation préféré décrira l'emploi de transistors de type NMOS pour réaliser la paire différentielle, il est clair que l'homme du métier pourra directement adapter la structure à une architecture dans laquelle la paire différentielle sera basée sur des transistors de type PMOS. L'amplificateur est alimenté au moyen d'une source d'alimentation délivrant une tension V_{dd}. L'électrode de source des transistors NMOS 10 et 20 est reliée à une source de courant 1 (I3) dont l'autre extrémité est connectée à la masse. Chaque transistor de la paire différentielle 10-20 est alimenté via son électrode de drain par une source de courant, respectivement basée sur un transistor PMOS 11 et sur un transistor PMOS 21 montés en miroir de courant. Les source et drain du transistor 11 (resp. transistor 12) sont respectivement connectées à la borne d'alimentation V_{dd} et au drain du transistor 10 (resp. transistor 20).

Les transistors 11 et 21 sont montés en miroir du courant coopérant avec un étage de gestion du mode commun qui comporte une seconde paire différentielle associée à une source de courant 2 (I4) et un transistor 5 de type PMOS. Plus particulièrement, la seconde paire différentielle comporte deux transistors 3 et 4 dont les sources sont connectées à une source de courant 2 (I4) présentant une autre extrémité connectée à la masse. Le drain des transistors 3 et 4 est respectivement connecté au drain du transistor 5 et à la borne d'alimentation V_{dd}. La grille du transistor 3 est connectée au point milieu d'un pont résistif, comportant deux résistances 17 et 27 de valeur généralement similaires, dont les extrémités sont connectées aux bornes de sorties O1 et O2 de l'amplificateur différentiel. Le pont résistif 17-27 est utilisé pour permettre l'obtention, en son point milieu, d'un potentiel représentatif de la valeur de mode commun des sorties O1 et O2 de l'amplificateur différentiel. La grille du transistor 4 reçoit une tension de consigne - V_{cm} - qui est utilisée pour régler le niveau de polarisation de l'étage en mode commun et que l'on fixe généralement à V_{dd}/2 de manière à obtenir une excursion maximale du signal de sortie sur les bornes O1 et O2.

Les électrodes de grilles des transistors 5 , 11 et 12 sont toutes connectées ensemble et la grille du transistor 5 est connecté au drain de ce même transistor, assurant ainsi son fonctionnement dans la zone quadratique de sa caractéristique I (V_{gs}). Les transistors sont ainsi montés en miroir de courant et sont parcourus par un même courant de drain puisque, étant sensiblement identiques, ils sont soumis aux mêmes variations de la tension grille-source V_{gs}.

La paire différentielle composée des transistors 10 et 20 sert de premier étage à un second étage de gain de type Miller, lequel est composé d'une paire de transistors 12 et 22 de type PMOS montés en source commune. Plus précisément, le drain du transistor 10 (resp. 20) est connecté à la grille du transistor 12 (resp. 22), dont la source est connectée à la borne d'alimentation V_{dd}. Le drain du transistor 12 (resp. 22) est connecté à une source de courant 14 (resp. 24), elle-même connectée, à son autre extrémité à la masse. Le drain du transistor 12 (resp. 22) est également connecté à l'électrode de sortie O2 (resp. 01) de l'amplificateur différentiel. Un condensateur 13 (resp. 23) vient compléter la structure de Miller et se connecte entre le drain et la source du transistor 12 (resp. 22). Le condensateur est dimensionné de manière à fixer le produit gain-bande de l'étage de Miller correspondant. Il est à noter que ce dernier est conçu pour fonctionner en classe A et les sources de courant 14 et 24 seront donc dimensionnées en conséquence, de manière à pouvoir écouler le courant appelée dans la charge de l'amplificateur.

L'association de la paire différentielle 10-20 et des étages de gain de Miller 12-22 permet d'assurer à l'ensemble de l'amplificateur un gain en boucle ouverte particulièrement élevé et de fixer en outre son produit gain-bande. Des résistances de contre-reaction 15 (R1), 16 (R2), 25 (R3) et 26 (R4) viennent fixer le gain en boucle fermée à la valeur souhaitée qui est R1/R2 = R3/R4. Plus précisément, comme on le voit sur la figure 1, l'ensemble 15 et 16 constitue un pont de résistance dont les extrémités sont respectivement connectées à l'électrode de sortie O1 et l'électrode d'entrée E1 de l'amplificateur différentiel, et dont le point milieu est connecté à la grille du transistor 10. De la même manière, les résistances 25 et 26 constituent un pont dont les extrémités sont respectivement connectées à l'électrode de sortie O2 et l'électrode d'entrée E2, et dont le point milieu est connecté à la grille du transistor 20.

Comme on le voit sur la figure 1, le circuit de gestion du mode commun permet de fixer les potentiels en mode commun autour de la valeur de consigne, à savoir V_{cm} = V_{dd} /2. En effet, on constate que si le potentiel de l'une des sorties venait à s'élever pour une raison quelconque, par exemple un accroissement de la température du circuit, cette élévation se répercuterait au niveau du point milieu du pont résistif 17-27, entraînant ainsi une élévation correspondante de la tension de grille du transistor 3. Ce dernier serait alors parcouru par un afflux de courant puisque la tension de grille du transistor complémentaire 4 resterait fixée à la valeur inchangée de la consigne Vcm. Les courants dans les transistors 11 et 21 seraient alors modifiés provoquant ainsi un retour de la tension de sortie vers la valeur de consigne.

On constate cependant que, lors du démarrage un tel circuit peut rester bloquer du fait du blocage des sources de courant matérialisées par les transistors 11 et 21. En effet, lors du démarrage, il s'avère que les tensions aux bornes E1, E2, O1 et O2 sont toutes fixées à la masse, ce qui correspond à un régime stable. Dans cette situation, tout le courant I4 fourni par la source 2 est entièrement dérivé par le transistor 4 seul et le transistor 3 n'est parcouru par aucun courant. Tous les autres transistors 5, 11, 21 sont alors bloqués et l'amplificateur ne peut fonctionner. De la même manière la source 1 reste alors bloquée.

Même lorsque les tensions des bornes E1 et E2 ont atteint une valeur convenable, par exemple V_{dd}/2 , découlant par exemple de la mise en régime permanent de l'étage amplificateur en amont, un blocage de la paire de transistors 10 et 20 n'est pas à exclure. Cela peut être le cas pour certaines configurations des valeurs de résistances de contre-réaction R1-R2, et R3-R4, notamment lorsque l'amplificateur est monté en atténuateur de tension. Dans ce cas, la présence d'un potentiel de mode commun sur les deux électrodes d'entrées E1 et E2 peut ne pas suffire à assurer la conduction des transistors 3, 5, 11 et 21 et permettre le fonctionnement de l'amplificateur en mode linéaire.

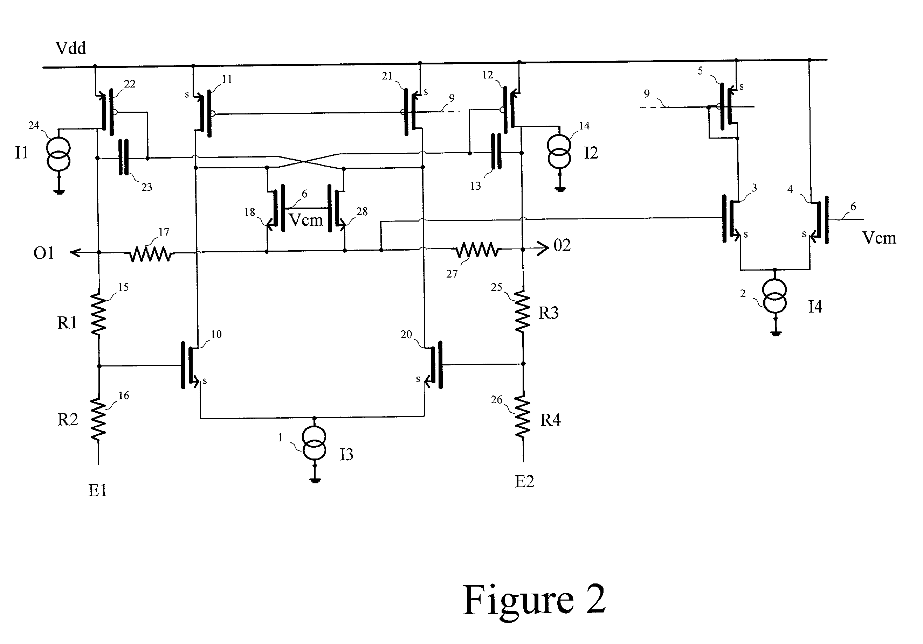

Afin d'éviter le blocage de la source de courant 1 qui est préjudiciable au fonctionnement général de l'amplificateur, on insère un dispositif de déverrouillage qui s'avère particulièrement simple et efficace, et que l'on va décrire à présent en référence avec la figure 2. Dans un souci de clarté, les éléments qui sont communs à la figure 1 conserve une référence commune. L'amplificateur comporte à nouveau la paire différentielle 10-20, l'étage de gestion de mode commun 3-4 et l'étage de gain de Miller composé des transistors 12 et 22. Pour assurer la conduction des transistors 12 et 22, le circuit comporte une paire supplémentaire de transistors de type NMOS qui sont branchés entre, d'une part, le point milieu du pont résistif 17-27 de manière à suivre le niveau en mode commun des potentiels de sortie O1 et O2 et, d'autre part, les grilles des transistors de l'étage de Miller. Ainsi permettent-ils, lors du démarrage, de mettre en conduction les étages de Miller. A cet effet, comme on le voit sur la figure 2, on dispose un premier transistor 18 de type NMOS dont le drain est connecté à la grille du transistor 12 et dont la source est connectée au point milieu du pont de résistance 17 et 27 captant le potentiel de mode commun. On dispose également un second transistor 28 de type NMOS comportant un drain connecté à la grille du transistor 22 et une source connectée au point milieu du pont de résistance mesurant la valeur de mode commun. Les grilles des deux transistors 18 et 28 sont communes et recoivent la tension de consigne V_{cm}. Ainsi, lorsque les potentiels de O1 et O2 sont anormalement bas - ce qui est le cas durant la phase de démarrage - les transistors NMOS 18 et 28 conduisent et mettent ainsi en conduction les transistors correspondant de l'étage de Miller - respectivement 12 et 22 - assurant ainsi l'élévation du potentiel de mode commun et, par suite, le démarrage du courant dans le transistor 5 et les miroirs formés des transistors 11 et 21, et enfin celui de la paire différentielle 10-20..

Le circuit de déverrouillage qui est proposé se révèle donc particulièrement efficace et, comme on le voit sur la figure, nécessite que deux composants supplémentaires. Il en résulte une intégration sans difficulté sur un circuit semi-conducteur. En outre, on constate que les transistors de déverouillage 18 et 28 peuvent être des transistors de très petite taille puisqu'une résistance de quelque ohms en conduction suffit à assurer le déblocage de l'étage de Miller. Tous les amplificateurs différentiels pourront donc être dotés sans difficulté, et sans surcoût, d'un tel dispositif de déverrouillage qui s'inhibe sans difficulté automatiquement dès le régime linéaire permanent établi ce qui est un avantage par rapport aux systèmes de déverouillage connus. On constate en effet que dès que la tension de mode commun atteint la valeur de consigne Vcm, les deux transistors 18 et 19 se bloquent permettant ainsi le fonctionnement de l'amplificateur en mode linéaire. Il n'y a donc pas besoin, ici, de circuit d'inhibition supplémentaire tels que ceux des systèmes connus.

Le dispositif de déverrouillage est donc particulièrement adapté à la réalisation d'amplificateurs différentiels et à leur intégration sur des circuits intégrés.

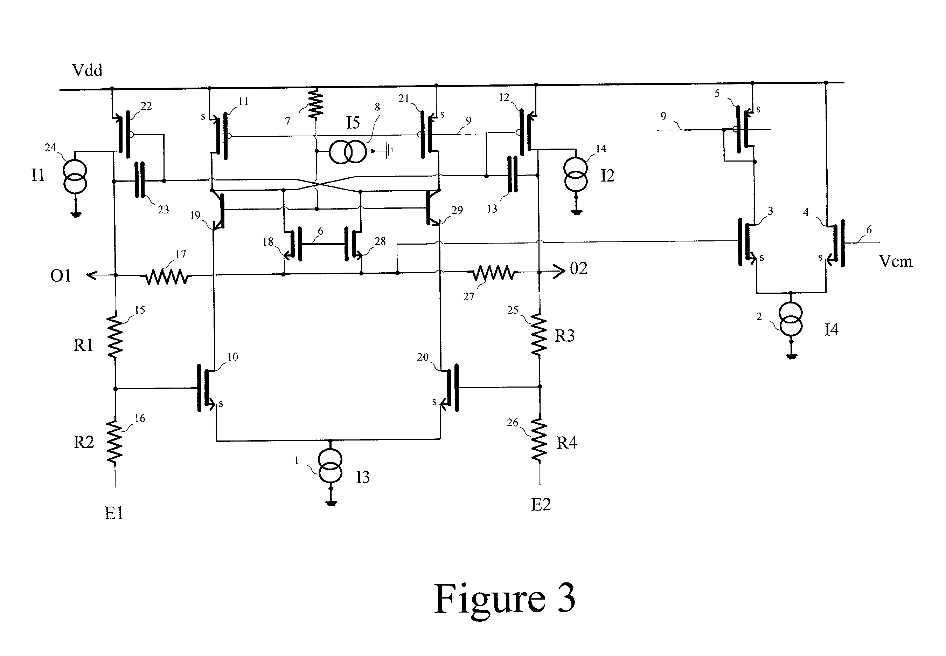

La figure 3 montre un autre mode de réalisation pour une structure différentielle comportant, outre l'étage de gain de Miller, un circuit cascode réalisant un suiveur adaptateur d'impédance entre la paire différentielle 10-20 et l'étage de Miller. Dans ce mode de réalisation l'électrode de drain du transistor 10 n'est pas directement connectée à l'électrode de drain du transistor 11, mais un transistor bipolaire 19 de type NPN vient s'intercaler entre les deux transistors 10 et 11. Plus précisément, l'émetteur et le collecteur du transistor 19 sont respectivement connectés au drain du transistor 10 et au drain du transistor 11. De la même manière, un transistor bipolaire 29, également de type NPN, vient s'intercaler entre le transistor 20 et le transistor 21. Plus précisément, l'émetteur et le collecteur du transistor 29 sont respectivement connectés au drain du transistor NMOS 20 et au drain du transistor 21. Les bases des deux transistors bipolaires sont connectées à une résistance 7 ramenant au potentiel d'alimentation V_{dd} et à une source de courant 8 dont l'autre extrémité est connectée à la masse. Le circuit cascode présente l'avantage, comme cela est connu de l'homme du métier, de présenter une impédance importante au premier étage constituée par la paire de transistors 10 et 20 de manière à accroître encore le gain en boucle ouverte de l'amplificateur.

Comme on le voit, le circuit d'amplificateur qui est proposé s'adapte parfaitement à la technologie bi-CMOS. Il est à noter, en outre, que l'homme du métier pourra très facilement adapter la structure de la figure 3 à l'emploi d'un circuit cascode composé de transistors de type NMOS et non plus simplement bipolaires.

## Revendications

1. Circuit amplificateur différentiel disposant de deux électrodes d'entrées (E1, E2), deux électrodes de sortie (O1, O2) et comportant
- un premier étage composé d'un premier et second transistor (10, 20) de même polarité et montés en amplificateur différentiel, lesdits premier et second transistor étant respectivement alimentés par une première et une seconde source de courant miroir (11, 21) dont le courant est commandé par un circuit de contrôle gérant le mode commun (2, 3, 4, 5) ayant deux entrées respectivement recevant une valeur de consigne V_{cm} et le potentiel d'une électrode qui est représentatif du potentiel de mode commun desdites sorties (O1, O2) ;
- un second étage de gain de Miller dont les sorties sont connectées aux dites électrodes de sortie (O1, O2), ledit second étage comportant un troisième et un quatrième transistor (12, 22) de type inverse des précédents et dont les entrées recoivent les signaux de sorties dudit premier étage,
**caractérisé en ce que** le circuit comporte :
- un circuit de déverrouillage (18, 28), inséré entre ledit potentiel représentatif du potentiel de mode commun et les entrées dudit étage de Miller, pour provoquer un court-circuit résistif et assurer la conduction desdits troisième et quatrième transistors aux fins d'établir le démarrage du circuit amplificateur différentiel.

2. Circuit amplificateur différentiel selon la revendication 1 **caractérisé en ce que** lesdits premier, second, troisième et quatrième transistors sont respectivement des transistors de type NMOS, NMOS, PMOS et PMOS, et **en ce que** l'étage de gain de Miller comporte deux transistors de type PMOS montés en source commune et dont les drains sont respectivement connectées aux dites sorties O1 et O2 et dont les grilles sont respectivement connectées de manière à recevoir le signal de sortie correspondant dudit premier étage.

3. Circuit amplificateur différentiel selon la revendication 2 **caractérisé en ce que** lesdits moyens de déverrouillage sont constitués de deux transistors de type NMOS présentant chacun une source, un drain et une grille;
- le drain de chacun des dits transistors NMOS de déverrouillage étant connecté à la grille correspondante de l'un desdits troisième et quatrième transistors PMOS,
- la source de chacun desdits transistors NMOS de déverrouillage étant connectée à la dite électrode représentative du potentiel de mode commun ;
- la grille de chacun desdits transistors NMOS de déverrouillage étant connectée à la valeur de consigne V_{cm} de manière à provoquer sa conduction dès lors que la valeur réelle du potentiel de mode commun est inférieure d'une manière significative à ladite valeur de consigne V_{cm}.

4. Circuit amplificateur différentiel selon la revendication 3 **caractérisé en ce qu'**un étage cascode ou suiveur est inséré entre ledit premier étage et le second étage de gain de Miller.

5. Circuit amplificateur différentiel selon la revendication 4 **caractérisé en ce que** ledit étage cascode est réalisé au moyen de deux transistors bipolaires de type NPN.

6. Circuit amplificateur différentiel selon la revendication 4 **caractérisé en ce que** ledit étage cascode est réalisé au moyen de deux transistors de type NMOS.

7. Circuit amplificateur différentiel selon la revendication 3 **caractérisé en ce qu'**un pont résistif (17, 27) est utilisé pour permettre, d'une part, la détermination du potentiel de mode commun et la mise en conduction desdits troisième et quatrième transistors de l'étage de Miller.

8. Circuit amplificateur selon la revendication 1 dans lequel :
- lesdits premiers et second transistors sont de type NMOS montés en paire différentielle dont les grilles reçoivent les signaux d'entrées (E1, E2) via des résistances de contre-réaction, dont la source commune est connectés à une troisième source de courant ;
- lesdits troisième et quatrième transistor de l'étage de Miller sont de type PMOS montés en source commune et associés chacun à une source de courant et à un condensateur, le drain de chacun desdits troisième et quatrième transistor étant connectée à une des sorties dudit amplificateur (O1, O2) et lesdits troisième et quatrième transistors présentent une grille ;
et **caractérisé en ce qu'**il comporte en outre :
- un cinquième et sixième transistor de type PMOS pour réaliser lesdites première et seconde source de courant alimentant respectivement les premiers et second transistors de la paire différentielle, lesdits cinquième et sixième transistor étant montés en source commune et présentant chacun un drain qui est connecté au drain correspondant de l'un desdits premier et second transistor de la paire différentielle, et présentant en outre une grille qui est commandée par ledit circuit de gestion du mode commun.
- un circuit de déverrouillage comportant un septième et huitième transistors de type NMOS, présentant une grille recevant la valeur de consigne Vcm et servant à court-circuiter ledit potentiel de mode commun et la grille desdits troisième et quatrième transistors de l'étage de Miller dès lors que la tension de mode commun tombe d'une manière significative en deçà de la valeur de consigne V_{cm}.

9. Circuit amplificateur selon la revendication 8, **caractérisé en ce que** les septième et huitième transistors sont de type bipolaire NPN.

10. Circuit amplificateur selon la revendication 1 **caractérisé en ce qu'**il est adapté à la constitution d'un amplificateur de transmission de données de type A.T.M. ou X.S.D.L.
